# DEMANDE DE BREVET EUROPEEN

(11) **EP 1 632 996 A2**
(43) Date de publication de la demande: **08.03.2006**
(21) Numéro de dépôt: 05291691.3
(22) Date de dépôt: 08.08.2005
(51) Int. Cl.: H01L 21/768

(54) **Circuit intégré comprenant des lignes de cuivre et procédé de formation de lignes de cuivre**

(30) Priorité: 07.09.2004 FR 0409467
(71) Demandeur: STMicroelectronics SA, 92120 Montrouge (FR)
(72) Inventeur: Caubet, Pierre, 38420 Le Versoud (FR); Grégoire, Magali, 38000 Grenoble (FR)
(74) Mandataire: Dossmann, Gérard

(57) **Abrégé**

La présente demande a pour objet un circuit intégré comprenant des lignes de cuivre, caractérisé en ce que la structure cristalline du cuivre a une orientation cristalline <001> supérieure à 30% et une orientation cristalline <111> inférieure à 20%.

## Description

La présente invention est relative à la formation de lignes de cuivre au sein d'un circuit intégré.

Dans les circuits intégrés comprenant des lignes de cuivre, lors du dépôt de couches de matériaux diélectriques sur les lignes de cuivre, on observe la formation d'excroissances de cuivre, encore appelées « hillocks ». Les hillocks résultent d'un réarrangement structurel des couches minces de cuivre, activé par la température. Ils se forment aux joints de grain du cuivre, généralement lors du dépôt de couches de matériau diélectrique sur les lignes de cuivre, après polissage mécano-chimique du cuivre. La densité des hillocks dépend des propriétés microstructurales du dépôt de cuivre.

L'influence des hillocks est néfaste, car lorsqu'ils croissent entre les lignes de métal, ils peuvent causer des fuites, et même des courts-circuits. En effet, la taille des hillocks peut atteindre jusqu'à 100 nm.

Plusieurs tentatives ont déjà été effectuées pour essayer de limiter la formation des hillocks. Il est connu que la modification des paramètres intrinsèques au dépôt électrolytique du cuivre, ou des recuits du dépôt de cuivre à des températures diverses peuvent diminuer la densité d'hillocks. Il est également connu que de déposer des couches de matériau diélectrique avec un plasma de NH₃/H₂, ou de supprimer l'étape de recuit entre le dépôt électrolytique du cuivre et le polissage mécano-chimique du cuivre génère une diminution de la quantité de ces défauts. On a également essayé d'introduire une étape de recuit après le polissage mécano-chimique du cuivre.

Toutefois, ces procédés ne sont pas satisfaisants, et il apparaît souhaitable de disposer de circuits intégrés permettant de limiter, voire d'éviter la formation de ces excroissances de cuivre, ainsi que d'un procédé permettant d'éviter la formation d'hillocks, et ce quelles que soient les épaisseurs et les largeurs des lignes de cuivre.

La demanderesse a observé de manière surprenante que la densité et la taille des hillocks étaient fortement réduites lorsque le cuivre présente une orientation cristalline <001> supérieure à 30% et une orientation cristalline <111> inférieure à 20%.

Elle a constaté que cette microstructure particulière du cuivre permettait de limiter les pertes de rendement dans le circuit et d'améliorer la fiabilité des circuits.

Elle a enfin observé que cette structure cristalline du cuivre pouvait être obtenue en mettant en oeuvre, lors de la formation de lignes de cuivre, et après le dépôt de cuivre dans des tranchées, une étape de recuit du cuivre sous atmosphère gazeuse d'un mélange N₂/H₂ à plus de 6% de H₂, à une température comprise entre 300 et 450°C, pendant une durée supérieure à 10 minutes.

L'invention propose donc un circuit intégré comprenant des lignes de cuivre, la structure cristalline du cuivre ayant une orientation cristalline <001> supérieure à 30% et une orientation cristalline <111> inférieure à 20%.

L'invention propose également un procédé de formation de lignes de cuivre d'un circuit intégré, comprenant les étapes successives suivantes :
a) dépôt de cuivre dans des tranchées,
b) recuit du cuivre sous atmosphère gazeuse d'un mélange N₂/H₂ à plus de 6% de H₂, à une température comprise entre 300 et 450°C, pendant une durée supérieure à 10 minutes, et
c) polissage mécano-chimique du cuivre.

Dans le circuit intégré selon l'invention, les lignes de cuivre peuvent comprendre des pistes métalliques et des vias d'interconnexion entre les pistes métalliques de niveaux différents.

Dans le procédé selon l'invention, la température du recuit est de préférence comprise entre 350 et 450°C.

Le recuit peut être effectué à une pression comprise entre 8.10⁴ et 1,2.10⁵ Pa (soit entre 600 et 900 Torr), et de préférence à pression atmosphérique.

L'étape de recuit est effectuée de préférence au plus tard 3 jours après le dépôt du cuivre, de préférence au plus tard 8 heures après le dépôt du cuivre, et encore de préférence directement après le dépôt du cuivre.

De préférence, la phase de montée en température, jusqu'à la température de recuit, et la phase de descente en température, en dessous de la température de recuit, se font également sous atmosphère gazeuse d'un mélange N₂/H₂ à plus de 6% de H₂.

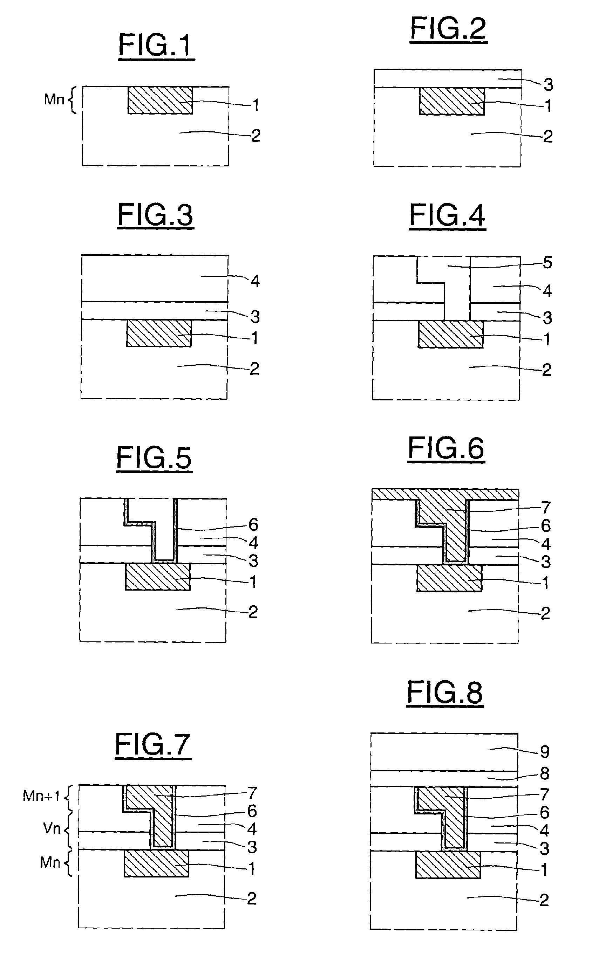

D'autres avantages et caractéristiques de l'invention apparaîtront à l'examen de la description détaillée de modes de mise en oeuvre et de réalisation nullement limitatifs, et des dessins annexés sur lesquels les figures 1 à 8 illustrent schématiquement les étapes principales d'un mode de mise en oeuvre du procédé de l'invention aboutissant à un mode de réalisation d'un circuit intégré selon l'invention.

Les figures 1 à 8 sont des coupes transversales du circuit intégré à différentes étapes du procédé de formation de lignes de cuivre de l'invention.

La figure 1 montre une ligne ou piste de cuivre 1 au niveau de métal Mn, entourée d'un matériau diélectrique 2. Le matériau diélectrique 2 est typiquement du FSG (en langue anglaise : Fluorinated Silica Glass).

On dépose (figure 2) sur la ligne 1 une couche barrière 3 de SiN, afin d'empêcher la migration du cuivre. L'épaisseur de la couche barrière 3 est par exemple de l'ordre de 400 Å.

On procède ensuite au dépôt d'une couche de matériau diélectrique 4 (figure 3). Le matériau diélectrique 4 est de préférence le FSG et l'épaisseur de la couche de matériau diélectrique 4 est par exemple de l'ordre de 85 nm.

On grave ensuite la couche barrière 3 et la couche de matériau diélectrique 4 de façon à former une tranchée 5. Le fond de la tranchée 5 est constitué par la ligne de cuivre 1 (figure 4). Puis les parois de la tranchée 5 sont recouvertes d'une couche barrière 6, tel qu'illustré sur la figure 5. Le matériau constituant la couche barrière 6 est avantageusement Ta et/ou TaN. On peut ainsi déposer sur les parois de la tranchée 5 une couche de TaN ayant une épaisseur de 10 nm, puis une couche de Ta ayant une épaisseur de 15 nm.

On dépose ensuite du cuivre 7 dans la tranchée 5 dont les parois sont recouvertes de la couche barrière 6 (figure 6). Le dépôt du cuivre 7 peut être effectué par toute technique connue de l'homme du métier, et notamment par électrodéposition ou par dépôt chimique en phase vapeur (CVD en langue anglaise : Chemical Vapor Deposition).

On met ensuite en oeuvre le recuit spécifique de l'invention. Le recuit du cuivre 7 a lieu sous atmosphère gazeuse d'un mélange N₂/H₂ à plus de 6% de H₂, à une température comprise entre 300 et 450°C, pendant une durée supérieure à 10 minutes. En dessous de 300°C, le recuit est inefficace, et au-delà de 450°C, on observe une dégradation des matériaux diélectriques du circuit intégré. La température du recuit est de préférence comprise entre 350 et 450°C. Le temps entre le recuit et l'étape de dépôt électrolytique est de préférence inférieur à 3 jours pour éviter la dégradation du dépôt de cuivre.

Grâce à la présence de H₂ à plus de 6% de H₂ dans l'atmosphère gazeuse, on observe une réduction des contraintes internes dans la couche de cuivre 7, ce qui privilégie ainsi une orientation cristalline <001>, au détriment de l'orientation cristalline <111>. Cette diminution des contraintes internes s'accompagne d'une limitation des phénomènes diffusifs, d'une augmentation de la taille des grains et d'une diminution de la densité et de la taille des hillocks.

Pour un recuit de 30 minutes, dont 14 minutes à 400°C, à pression atmosphérique, et avec une épaisseur de la ligne de cuivre de 700 nm, on a observé la structure cristalline suivante : <001> : 39,7% ; <221> : 33,1% ; <110> : 1,8% ; <210> : 4,6% ; <111> 6,4% ; <511> : 5,1% ; <211> : 7,5% ; <310> : 1,8%.

On procède ensuite à un polissage mécano-chimique du cuivre 7, afin d'enlever le cuivre 7 qui recouvre la couche de matériau diélectrique 4.

La figure 7 illustre le circuit intégré à l'issu des étapes de polissage mécano-chimique et de recuit. La piste de cuivre située au niveau de métal Mₙ₊₁ est relié à la piste du niveau de métal Mₙ par l'intermédiaire du via Vₙ.

La formation du circuit intégré, en particulier la formation du niveau de métal et du niveau de via supérieurs, se poursuit par le dépôt d'une couche barrière 8 de SiN, puis d'une couche de matériau diélectrique 9, généralement par dépôt chimique en phase vapeur (figure 8). L'épaisseur de la couche barrière 8 est de l'ordre de 40 nm. Le matériau diélectrique 9 est de préférence le FSG et l'épaisseur de la couche de matériau diélectrique 9 est de l'ordre de 850 nm.

Lors de la formation du matériau diélectrique 9, on observe une diminution importante de la densité et de la taille des hillocks.

## Revendications

1. Circuit intégré comprenant des lignes de cuivre, **caractérisé en ce que** la structure cristalline du cuivre a une orientation cristalline <001> supérieure à 30% et une orientation cristalline <111> inférieure à 20%.

2. Circuit intégré selon la revendication 1, **caractérisé en ce que** les lignes de cuivre comprennent des pistes métalliques et des vias d'interconnexion entre les pistes métalliques de niveaux différents.

3. Procédé de formation de lignes de cuivre d'un circuit intégré, comprenant les étapes successives suivantes :
a) dépôt de cuivre (7) dans des tranchées (5),
b) recuit du cuivre (7) sous atmosphère gazeuse d'un mélange N₂/H₂ à plus de 6% de H₂, à une température comprise entre 300 et 450°C, pendant une durée supérieure à 10 minutes, et
c) polissage mécano-chimique du cuivre (7).

4. Procédé selon la revendication 3, **caractérisé en ce que** la température du recuit est comprise entre 350 et 450°C.

5. Procédé selon la revendication 3 ou 4, **caractérisé en ce que** le recuit est effectué à une pression comprise entre 8.10⁴ et 1,2.10⁵ Pa, et de préférence à pression atmosphérique.

6. Procédé selon l'une des revendications 3 à 5, **caractérisé en ce que** la phase de montée en température, jusqu'à la température de recuit, et la phase de descente en température, en dessous de la température de recuit, s'effectuent également sous atmosphère gazeuse d'un mélange N₂/H₂ à plus de 6% de H₂.
